# EUROPEAN PATENT APPLICATION

(11) **EP 4 844 422 A1**
(43) Date of publication of application: **25.11.2026**
(21) Application number: 25382511.1
(22) Date of filing: 21.05.2025
(51) Int. Cl.: G01R 31/28, B82B 3/00

(54) **AN APPARATUS FOR USE WITH MECHANICAL-TO-ELECTRICAL ENERGY NANOGENERATORS**

(71) Applicant: Fundació Institut Català de Nanociència i Nanotecnologia (ICN2), 08193 Bellaterra (ES); Consejo Superior de Investigaciones Científicas (CSIC), 28006 Madrid (ES)
(72) Inventor: DEL CORRO, Elena, 08290 CERDANYOLA DEL VALLÉS (ES); MARTÍ CARRASCOSA, María, 08290 CERDANYOLA DEL VALLÉS (ES); CAICEDO ROQUE, José Manuel, 08031 BARCELONA (ES); GUIMERÀ BRUNET, Antón, 08193 CERDANYOLA DEL VALLÈS (ES)
(74) Representative: Ponti & Partners, S.L.P

(57) **Abstract**

The present invention relates to an apparatus for use with mechanical-to-electrical energy nanogenerators, comprising an electrical characterization device configured to electrically characterize each of a plurality of different mechanical-to-electrical energy nanogenerators (N), wherein those different electrical mechanical-to-electrical energy nanogenerators (N) differ at least in their respective physical properties for transducing mechanical to electrical energies.

In the apparatus of the present invention, the electrical characterization device comprises a variable electrical impedance arrangement (Za) configured to vary its impedance value to provide a load impedance adapted to each of the plurality of different mechanical-to-electrical energy nanogenerators (N).

## Description

### FIELD OF THE INVENTION

The present invention relates to an apparatus for use with mechanical-to-electrical energy nanogenerators, comprising an electrical characterization device adapted to electrically characterize each of a plurality of different mechanical-to-electrical energy nanogenerators.

### BACKGROUND OF THE INVENTION

The output signal of some mechanical-to-electrical energy nanogenerators, for example but not only for triboelectric nanogenerators (TENG), is governed by the device specifications in terms of materials stacking and design (size), but also it is strongly affected by the ambient conditions, the actuation parameters and the electrical measurement systems, which gives rise to a big challenge when comparing and benchmarking different mechanical-to-electrical energy nanogenerators outputs among the research community.

Due to the high internal impedance of TENGs, their output characteristics consist of high voltage-low current signals, at high frequency. Such complexity has led to a lack of consensus in the literature about what commercially available system to use for TENG electrical characterization. Most advanced studies use both an oscilloscope and an electrometer, through a DAQ, to simultaneously measure the open circuit voltage and the short circuit current (at a fixed load resistance), respectively. This configuration is challenging for a non-expert researcher and moreover, it can lead to signal missing, especially when characterizing novel TENG materials and devices of unspecified internal impedance.

Jien An et al, Methods for correctly characterizing the output performance of nanogenerators, Nano Energy 93 (2022) 106884, discloses an apparatus for use with mechanical-to-electrical energy nanogenerators, comprising an electrical characterization device configured to electrically characterize each of a plurality of different mechanical-to-electrical energy nanogenerators, wherein said different electrical mechanical-to-electrical energy nanogenerators differ at least in their respective physical properties for transducing mechanical to electrical energies.

The apparatus disclosed in Jien An et al. is a modified multi-functional electrometer including a non-variable reduced internal capacitance, optimized from an ideal nanogenerator based on lumped model, in order to provide a standard characterization system for nanogenerators.

Although the proposal made in Jien An et al. provides an electrical characterization device for a plurality of different mechanical-to-electrical nanogenerators, the apparatus there disclosed will provide better results with some nanogenerators than with others, since it does not adapt to each of those nanogenerators.

It is therefore necessary to offer an alternative to the state of the art, which covers the gaps mentioned above, particularly by providing an apparatus for use with mechanical-to-electrical energy nanogenerators which does not have the above mentioned drawbacks and limitations.

### SUMMARY OF THE INVENTION

To that end, the present invention relates to an apparatus for use with mechanical-to-electrical energy nanogenerators, comprising an electrical characterization device configured to electrically characterize each of a plurality of different mechanical-to-electrical energy nanogenerators, wherein said different electrical mechanical-to-electrical energy nanogenerators differ at least in their respective physical properties for transducing mechanical to electrical energies.

In contrast to the apparatus for use with mechanical-to-electrical energy nanogenerators of the prior art, in the one of the present invention the electrical characterization device comprises a variable electrical impedance arrangement configured to vary its impedance value to provide a load impedance adapted to each of said plurality of different mechanical-to-electrical energy nanogenerators.

For an embodiment, the variable electrical impedance arrangement comprises a variable electrical resistance arrangement configured to vary its electrical resistance. However, components other than resistances (capacitors and/or inductors) may also be included in the variable electrical impedance arrangement, for some embodiments.

According to an embodiment, the variable electrical impedance arrangement automatically varies its electrical impedance value across a range of impedance values for electrically characterizing each of said plurality of different mechanical-to-electrical energy nanogenerator over a sweep of different load impedance values, to at least determine its optimal load conditions.

For an implementation of that embodiment, the variable electrical impedance arrangement is implemented in the form of an automatic load impedance switching circuit.

In an embodiment, the variable electrical impedance arrangement implements a voltage attenuator or voltage amplifier that, when the electrical characterization device is electrically connected to an electrical output of one of said plurality of electrical mechanical-to-electrical energy nanogenerators to electrically characterize the same, respectively attenuates or amplifies an output voltage provided at said electrical output, providing an attenuated or amplified voltage at a voltage sensing connection.

According to an implementation of that embodiment, the electrical characterization device further comprises a control unit electrically and operatively connected to a voltage sensor electrically connected to said voltage sensing connection to receive attenuated or amplified voltage signals, to a current sensing connection through which a current signal flowing through the electrical mechanical-to-electrical energy nanogenerator electrically connected to the electrical characterization device flows, and to the variable electrical impedance arrangement to automatically control the latter based at least on the values of the received attenuated or amplified voltage signals and/or output current signal, implementing a closed-loop control.

In a further embodiment, the apparatus of the present invention further comprising a synchronization device configured and arranged to be electrically and operatively connected to the electrical characterization device and to an actuator in charge of providing a mechanical actuation on the mechanical-to-electrical energy nanogenerator to be electrically characterized, to synchronize said mechanical actuation with the electrical characterization of the electrical mechanical-to-electrical energy nanogenerator.

For an embodiment, the electrical characterization device further comprises a data acquisition device comprising an analogue-to-digital converter to be connected to an electrical output of the electrical mechanical-to-electrical energy nanogenerator to be electrically characterized, the variable electrical impedance arrangement being configured to vary its impedance value also to adapt the electrical output signals provided at that electrical output to the electrical specifications of said data acquisition device, for example by means of the aforementioned voltage attenuation or amplification.

For an embodiment, the data acquisition device is equipped with a printed circuit board with the variable impedance arrangement implemented in the form of resistance arrays that can be automatically switched by the control unit.

According to an implementation of that embodiment, the synchronization device comprises a trigger element configured to be electrically and operatively interconnecting the above mentioned actuator with the electrical characterization device, said trigger element being configured and arranged to (manually, semiautomatically or automatically) activate simultaneously the operation of the actuator and the recording of detection signals representative of mechanical displacements caused by the actuator and of the electrical output signals provided at the electrical output of the electrical mechanical-to-electrical energy nanogenerator to be electrically characterized.

For a variant of that implementation, the apparatus of the present invention further comprises a data post-processing device operatively connected to the data acquisition device for receiving data acquired thereby and configured to post-process the received data to at least correlate cinematic and electrical parameters extracted from the recorded detection and electrical output signals.

According to an embodiment, the actuator is or comprises at least a linear motor.

For an embodiment, the apparatus of the present invention further comprises the aforementioned actuator.

For an embodiment, the apparatus of the present invention further comprises a Faraday cage for housing, in a sealed manner, the actuator and the mechanical-to-electrical energy nanogenerator to be characterized.

For an implementation of that embodiment, the apparatus of the present invention further comprises a temperature and humidity active device, placed within the Faraday cage, comprising temperature and humidity sensors operatively connected to a controller to provide the latter with temperature and humidity measurements, air heaters operatively connected to said controller device to receive orders therefrom to activate for heating the air within the Faraday cage, and at least one flow direction valve for letting more or less humid air enter and/or exit the Faraday cage through at least one air conduct, to provide controlled environmental conditions.

According to a variant of that implementation, the electrical characterization device comprises the aforementioned controller and is configured to carry out the electrical characterization of the electrical mechanical-to-electrical energy nanogenerator under said controlled environmental conditions.

Therefore, the present invention indeed constitutes a unified system, capable of performing mechanical-to-electrical energy nanogenerators measurements always under the same conditions and overcoming the electronic mismatches problems.

In an embodiment, the electrical characterization device is configured to electrically characterize each of the plurality of different mechanical-to-electrical energy nanogenerators, including different triboelectric nanogenerators, each including at least one triboelectric element and/or at least one dielectric element, relatively moveable, by at least said actuator, according to approaching/distancing directions and/or sliding directions, for contact mode and/or non-contact mode, and for single-electrode mode or multi-electrode mode.

For an implementation of that embodiment, the apparatus of the present invention further comprises, placed within the Faraday cage, at least one sample holder for holding the at least one triboelectric element and/or the at least one dielectric element.

For other embodiments, the electrical characterization device is configured to electrically characterize each of the plurality of different mechanical-to-electrical energy nanogenerators, including different piezoelectric nanogenerators and/or different hybrid piezo- triboelectric nanogenerators.

The control unit, controller and data post-processing device can be implemented as separate but operatively interconnected computing entities or by the same computing entity, including, for an embodiment, at least one processor and operatively connected thereto, data storage unit(s) and electric and electronic circuitry, and may include input/output user interfaces.

The at least one processor may be implemented as one or more microprocessors, microcomputers, microcontrollers, digital signal processors, central processing units, state machines, logic circuitries, and/or any devices that manipulate signals based on operational instructions. Among other capabilities, the at least one processor is configured to fetch and execute computer-readable instructions stored in the data storage unit(s).

Different computing entities can be used, according to different embodiments, for implementing the processing capabilities of the control unit, controller and data post-processing device, whether including local and/or remote computing entities, communicated through corresponding communication links (wired or wirelessly), for distributed or non-distributed computing.

### BRIEF DESCRIPTION OF THE FIGURES

In the following some preferred embodiments of the invention will be described with reference to the enclosed figures. They are provided only for illustration purposes without however limiting the scope of the invention. In accordance with common practice, the components in the figures are drawn to emphasize specific features and they are not drawn to the right scale.

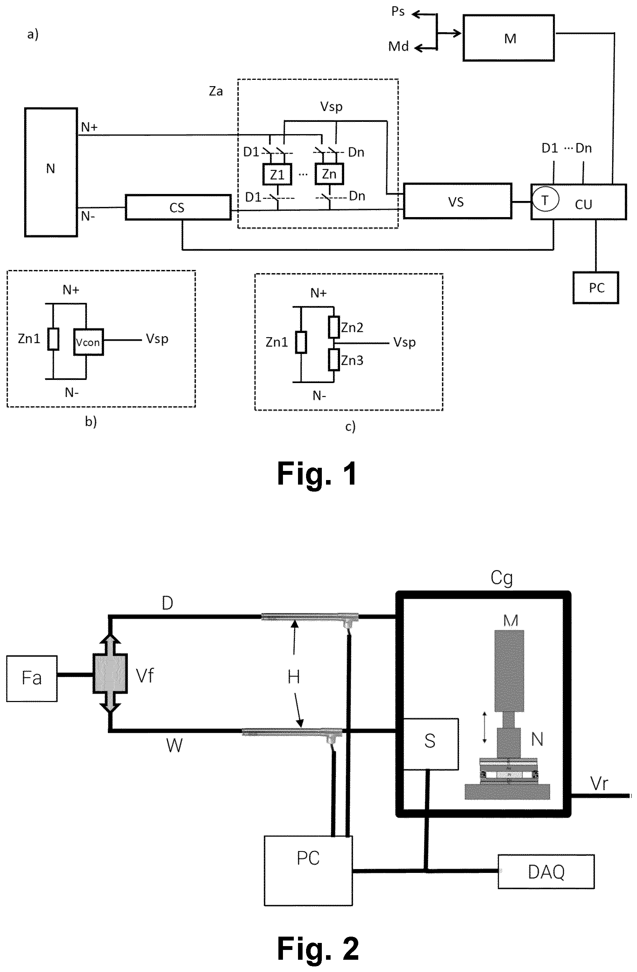

Figure 1 view a) schematically shows the apparatus of the present invention, for an embodiment, electrically and operatively connected to a mechanical-to-electrical energy nanogenerator. View b) shows a details of an impedance group of the variable electrical impedance arrangement, for a generic embodiment including a generic voltage conditioning arrangement, while view c) shows a more specific embodiment where the voltage conditioning arrangement is a voltage divider for voltage attenuation.
Figure 2 schematically shows the apparatus of the present invention, for another embodiment, electrically and operatively connected to a mechanical-to-electrical energy nanogenerator placed within a faraday cage, and to other components for providing controlled environmental conditions.

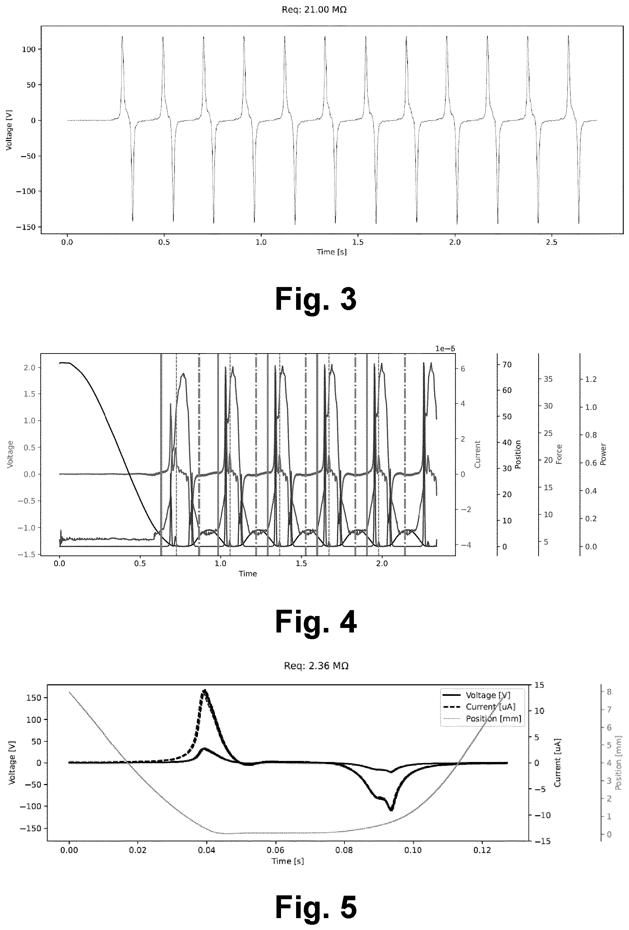

Figure 3 is a plot showing an example of voltage output data experimentally obtained with the apparatus of the present invention, for an embodiment, from a triboelectric nanogenerator for a specific load impedance value, specifically of 21 MΩ, provided with the variable electrical impedance arrangement, and subsequent cycles.
Figure 4 is a plot showing an example of synchronized mechanical and electrical data experimentally obtained with the apparatus of the present invention, for an embodiment, from a triboelectric nanogenerator for a specific load impedance value, specifically of 330 kΩ, provided with the variable electrical impedance arrangement, and subsequent cycles.
Figure 5 is a plot showing an example of synchronized mechanical and electrical data experimentally obtained with the apparatus of the present invention, for an embodiment, from a triboelectric nanogenerator for a specific load impedance value, specifically of 2.36 MΩ, provided with the variable electrical impedance arrangement, and overlapped for all cycles.

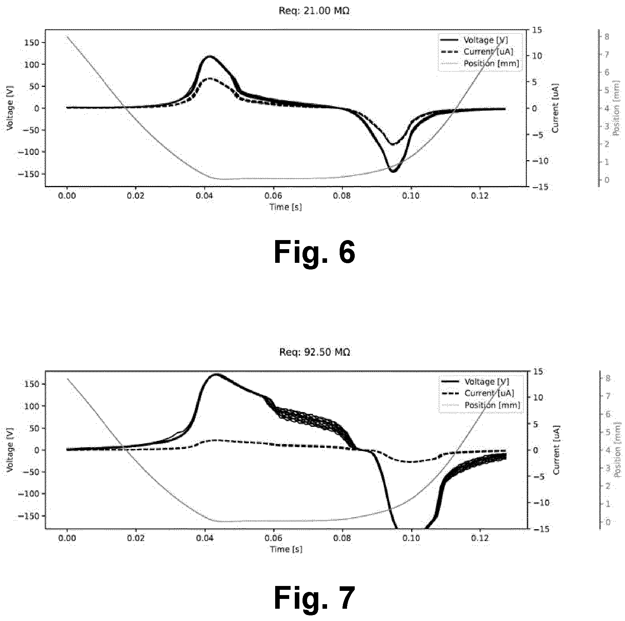

Figure 6 is a plot showing an example of synchronized mechanical and electrical data experimentally obtained with the apparatus of the present invention, for another embodiment, from a triboelectric nanogenerator for a specific load impedance value, specifically of 21 MΩ, provided with the variable electrical impedance arrangement, and overlapped for all cycles.
Figure 7 is a plot showing an example of synchronized mechanical and electrical data experimentally obtained with the apparatus of the present invention, for another embodiment, from a triboelectric nanogenerator for a specific load impedance value, specifically of 92.5 MΩ, provided with the variable electrical impedance arrangement, and overlapped for all cycles.

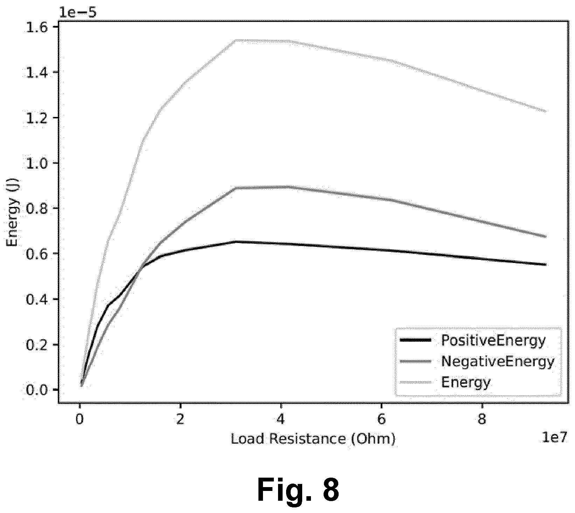

Figure 8 is a plot showing an example of processed averaged data of energy as a function of the used load impedance values, provided with the variable electrical impedance arrangement, experimentally obtained with the apparatus of the present invention, for an embodiment, from a triboelectric nanogenerator.

### DESCRIPTION OF THE PREFERRED EMBODIMENTS

As schematically shown in Figures 1-2, the present invention relates to an apparatus for use with mechanical-to-electrical energy nanogenerators N, comprising an electrical characterization device configured to electrically characterize each of a plurality of different mechanical-to-electrical energy nanogenerators N, wherein said different electrical mechanical-to-electrical energy nanogenerators N differ at least in their respective physical properties for transducing mechanical to electrical energies.

As shown in Figure 1, the electrical characterization device comprises a variable electrical impedance arrangement Za configured to vary its impedance value to provide a load impedance adapted to each of said plurality of different mechanical-to-electrical energy nanogenerators N.

For the illustrated embodiment, the variable electrical impedance arrangement Za automatically varies its electrical impedance value across a range of impedance values for electrically characterizing each of the plurality of different mechanical-to-electrical energy nanogenerators N over a sweep of different load impedance values, to at least determine its optimal load conditions.

The variable electrical impedance arrangement Za is implemented in the form of an automatic load impedance switching circuit, as shown in Figure 1, for an embodiment.

Particularly, in the embodiment of Figure 1, the variable electrical impedance arrangement Za implements a voltage conditioning arrangement Vcon for voltage attenuation or voltage amplification that, when the electrical characterization device is electrically connected to an electrical output N+, N- of the respective electrical mechanical-to-electrical energy nanogenerator N to electrically characterize the same, respectively attenuates or amplifies an output voltage provided at said electrical output N+, N-, providing an attenuated or amplified voltage at a voltage sensing connection Vsp.

That voltage conditioning arrangement Vcon is depicted in view b) of Figure 1 schematically as a block, while in view c) a possible implementation thereof is shown, particularly for voltage attenuation, in the form of a voltage divider circuit. Other circuits and arrangements different to that voltage divider circuit, for voltage attenuation and/or for voltage amplification, are envisaged to implement the voltage conditioning arrangement Vcon, for different embodiments.

The electrical characterization device further comprises a control unit CU electrically and operatively connected to a voltage sensor VS electrically connected to that voltage sensing connection Vsp to receive attenuated or amplified voltage sensing signals, to a current sensor CS through which a current signal flowing through the electrical mechanical-to-electrical energy nanogenerator N electrically connected to the electrical characterization device flows, and to the variable electrical impedance arrangement Za to automatically control the latter based at least on the values of the received attenuated or amplified voltage signals and/or received output current signal, implementing a closed-loop control.

As shown in Figure 1, the variable electrical impedance arrangement Za comprises a plurality of impedance groups Z1 to Zn, each selectable through switches D1 to Dn under the digital command of the control unit CU, and formed (as shown in the bottom detail) by an impedance Zn1 in parallel with the above mentioned voltage conditioning arrangement Vcon.

For the illustrated embodiment, the control unit is further connected to a computer entity PC, for further data processing or control purposes, some of which will be described further below.

The apparatus further comprising a synchronization device configured and arranged to be electrically and operatively connected to the electrical characterization device and to an actuator M in charge of providing a mechanical actuation on the mechanical-to-electrical energy nanogenerator N to be electrically characterized, to synchronize that mechanical actuation with the electrical characterization of the electrical mechanical-to-electrical energy nanogenerator N.

As shown in Figure 1, the control unit CU is also electrically and operatively connected to that actuator M, such as a linear motor, so that the control unit CU activates the loads Z1-Zn and synchronize motor actuation, i.e. provides ta aforementioned synchronization.

The electrical characterization device further comprises a data acquisition device (DAQ in Figure 2) comprising an analogue-to-digital converter connected to an electrical output of the voltage and current sensors VS, CS.

The variable electrical impedance arrangement Za is configured to vary its impedance value also to adapt the electrical output signals provided at that electrical output N+, N- to the electrical specifications of the data acquisition device

For that embodiment shown in Figure 1, the synchronization device comprises a trigger element T electrically and operatively interconnecting the actuator M with the electrical characterization device, including the data acquisition device (not shown in Figure 1, but arranged, for example, within control unit CU), the trigger element T being configured and arranged to activate simultaneously the operation of the actuator M and the recording of detection signals representative of mechanical displacements caused by the actuator M and of the electrical output signals provided at the electrical output of the electrical mechanical-to-electrical energy nanogenerator N to be electrically characterized.

That trigger element T has been depicted as a digital trigger button, which activates simultaneously the motor movement and the mechanical and electrical data recording. However, the trigger element T may be also activated semiautomatically or automatically, for other embodiments, and could also be just implemented by the control unit CU itself.

For the embodiment illustrated in Figure 1, the computer entity PC is operatively bidirectionally connected to the control unit CU, the latter being connected to the actuator M to receive data therefrom (such as from an encoder of the actuator) and send control commands to them. The computer entity PC and the control unit CU cooperate to carry out the control of the variable electrical impedance arrangement Za.

Specifically, the computer entity PC comprises a data post-processing device operatively connected to the control unit CU for receiving data acquired thereby and configured to post-process the received data to at least correlate cinematic and electrical parameters extracted from the recorded detection and electrical output signals.

In Figure 1, power supplies Ps and a motor driver Md are also electrically and operatively connected to the actuator M to respectively electrically feed and drive the same.

For the embodiment shown in Figure 2, the apparatus of the present invention comprises a Faraday cage Cg for housing, in a sealed manner, the actuator M, the mechanical-to-electrical energy nanogenerator N to be characterized, and a temperature and humidity active device, placed within the Faraday cage Cg, comprising temperature and humidity sensors S operatively connected to a controller PC to provide the latter with temperature and humidity measurements

Air heaters H arranged to heat air circulating through conducts D and W towards the interior of the faraday cage Cg are operatively connected to the controller PC to receive orders therefrom to activate for heating the air within the Faraday cage Cg. The sensor S inside the Faraday cage C continuously measures temperature and relative humidity, and provides the obtained measurements to the controller PC and/or data acquisition device DAQ.

When the ambient temperature is under the desired target, the controller PC activates air heaters H. When the target temperature is reached, the heaters H are turned off.

A flow direction valve Vf (which can be adjusted with a flowmeter adjuster Fa) and a release valve Vr are also provided for tuning humidity within the faraday cage Cg, by letting more or less humid air respectively enter and/or exit the Faraday cage Cg through the air conducts D, W, where conduct D provides dry air while conduct W provides wet air, to provide controlled environmental conditions. Humidity read-outs are performed with the data acquisition device DAQ.

The controller PC is configured to carry out the electrical characterization of the electrical mechanical-to-electrical energy nanogenerator N under those controlled environmental conditions. The use of the sealed Faraday cage Cg also avoids electromagnetic noise, allowing a proper standardization of the materials and devices.

The present inventors have performed several experiments with the apparatus of the present invention, with a TENG and several impedance values provided with the variable impedance arrangement Za. For data analysis a Python code was used. The synchronized mechanical and electrical data was imported, and postprocessed, different thresholds can be used for data average as single event. Then, statistical main output characteristics are measured and other parameters, such as power and energy, are derived.

The results of those experiments are shown in Figures 3 to 8. Figure 3 presents the voltage output data as a function of time, for a 21 MΩ load impedance. Figure 4 presents the synchronized mechanical and electrical data as a function of time for a 330 kΩ load impedance, including the voltage and the current output, the motor position and force, and the calculated power. Figures 5 to 7 presents the voltage and current output (overlapped cycles) at three load impedances (motor position information is also included): 2.36 MΩ (Figure 5), 21 MΩ (Figure 6), 92.5 MΩ (Figure 7). Figure 8 presents processed data (averaged cycles) of calculated energy, for the positive and negative output peaks and the sum, as a function of the used load impedance values.

In summary, with the proposed apparatus characterization set-up, researchers will be able to characterize unambiguously all TENG device (and of other types of mechanical-to-electrical energy nanogenerators) designs and materials, over a large range of parameters, in an easy and automated way, getting materials comparations and device characteristic figures-of-merit (energy, power, Voc, Isc) and its dependence on load resistance, ambient conditions and mechanical actuation parameters.

A person skilled in the art could introduce changes and modifications in the embodiments described without departing from the scope of the invention as it is defined in the attached claims.

## Claims

1. An apparatus for use with mechanical-to-electrical energy nanogenerators, comprising an electrical characterization device configured to electrically characterize each of a plurality of different mechanical-to-electrical energy nanogenerators (N), wherein said different electrical mechanical-to-electrical energy nanogenerators (N) differ at least in their respective physical properties for transducing mechanical to electrical energies, the apparatus being **characterized in that** said electrical characterization device comprises a variable electrical impedance arrangement (Za) configured to vary its impedance value to provide a load impedance adapted to each of said plurality of different mechanical-to-electrical energy nanogenerators (N).

2. The apparatus of claim 1, wherein said variable electrical impedance arrangement (Za) comprises a variable electrical resistance arrangement configured to vary its electrical resistance.

3. The apparatus of any of the previous claims, wherein said variable electrical impedance arrangement (Za) automatically varies its electrical impedance value across a range of impedance values for electrically characterizing each of said plurality of different mechanical-to-electrical energy nanogenerators (N) over a sweep of different load impedance values, to at least determine its optimal load conditions.

4. The apparatus of claim 3, wherein said variable electrical impedance arrangement (Za) is implemented in the form of an automatic load impedance switching circuit.

5. The apparatus of any of the previous claims, wherein said variable electrical impedance arrangement (Za) implements a voltage attenuator or voltage amplifier that, when the electrical characterization device is electrically connected to an electrical output (N+, N-) of one of said plurality of electrical mechanical-to-electrical energy nanogenerators (N) to electrically characterize the same, respectively attenuates or amplifies an output voltage provided at said electrical output (N+, N-), providing an attenuated or amplified voltage at a voltage sensing connection (Vsp).

6. The apparatus of claim 5 when depending on claim 3 or 4, wherein the electrical characterization device further comprises a control unit (CU) electrically and operatively connected to a voltage sensor (VS) electrically connected to said voltage sensing connection (Vsp) to receive attenuated or amplified voltage signals, to a current sensor (CS) through which a current signal flowing through the electrical mechanical-to-electrical energy nanogenerator (N) electrically connected to the electrical characterization device flows, and to the variable electrical impedance arrangement (Za) to automatically control the latter based at least on the values of the received attenuated or amplified voltage signals and/or output current signal, implementing a closed-loop control.

7. The apparatus of any of the previous claims, further comprising a synchronization device configured and arranged to be electrically and operatively connected to said electrical characterization device and to an actuator (M) in charge of providing a mechanical actuation on the mechanical-to-electrical energy nanogenerator (N) to be electrically characterized, to synchronize said mechanical actuation with the electrical characterization of the electrical mechanical-to-electrical energy nanogenerator (N).

8. The apparatus of claim 6 or claim 7 when depending on claim 6, wherein the electrical characterization device further comprises a data acquisition device (DAQ) comprising an analogue-to-digital converter to be connected to an electrical output of said voltage and current sensors (VS, CS), and wherein the variable electrical impedance arrangement (Za) is configured to vary its impedance value also to adapt the electrical output signals provided at that electrical output (N+, N-) to the electrical specifications of said data acquisition device (DAQ).

9. The apparatus of claim 8 when depending on claim 7, wherein said synchronization device comprises a trigger element (T) configured to be electrically and operatively interconnecting said actuator (M) with said electrical characterization device, said trigger element (T) being configured and arranged to activate simultaneously the operation of the actuator (M) and the recording of detection signals representative of mechanical displacements caused by the actuator (M) and of the electrical output signals provided at the electrical output of the electrical mechanical-to-electrical energy nanogenerator (N) to be electrically characterized.

10. The apparatus of claim 9, further comprising a data post-processing device operatively connected to said data acquisition device (DAQ) for receiving data acquired thereby and configured to post-process said received data to at least correlate cinematic and electrical parameters extracted from said recorded detection and electrical output signals.

11. The apparatus of any of the previous claims, wherein said electrical characterization device is configured to electrically characterize each of said plurality of different mechanical-to-electrical energy nanogenerators (N), including different triboelectric nanogenerators (N), each including at least one triboelectric element and/or at least one dielectric element, relatively moveable, by at least said actuator, according to approaching/distancing directions and/or sliding directions, for contact mode and/or non-contact mode, and for single-electrode mode or multi-electrode mode.

12. The apparatus of claim 7 or of any of claims 8 to 11 when depending on claim 7, wherein said actuator (M) is a linear motor.

13. The apparatus of claim 12, further comprising a Faraday cage (Cg) for housing, in a sealed manner, said actuator (M) and the mechanical-to-electrical energy nanogenerator (N) to be characterized.

14. The apparatus of claim 13, further comprising a temperature and humidity active device, placed within the Faraday cage (Cg), comprising temperature and humidity sensors (S) operatively connected to a controller (PC) to provide the latter with temperature and humidity measurements, air heaters (H) operatively connected to said controller (PC) to receive orders therefrom to activate for heating the air within the Faraday cage (Cg), and at least one flow direction valve (Vf, Vr) for letting more or less humid air enter and/or exit the Faraday cage (Cg) through at least one air conduct (D, W), to provide controlled environmental conditions.

15. The apparatus of claim 14, wherein the electrical characterization device comprises said controller (PC) and is configured to carry out said electrical characterization of the electrical mechanical-to-electrical energy nanogenerator (N) under said controlled environmental conditions.
